# EUROPEAN PATENT SPECIFICATION

(11) **EP 3 522 245 B1**
(45) Date of publication and mention of the grant of the patent: **14.12.2022**
(21) Application number: 17856256.7
(22) Date of filing: 27.09.2017
(51) Int. Cl.: C25D 11/04, H01L 51/42

(54) **FLEXIBLE SOLAR CELL**
FLEXIBLE SOLARZELLE
CELLULE SOLAIRE SOUPLE

(30) Priority: 28.09.2016 JP 2016189915
(43) Date of publication of application: 07.08.2019
(73) Proprietor: Sekisui Chemical Co., Ltd., Osaka-shi, Osaka 530-0047 (JP)
(72) Inventor: HAYAKAWA, Akinobu, Mishima-gun Osaka 618-0021 (JP); YUKAWA, Mayumi, Mishima-gun Osaka 618-0021 (JP); UNO, Tomohito, Mishima-gun Osaka 618-0021 (JP); ASANO, Motohiko, Mishima-gun Osaka 618-0021 (JP); FUKUMOTO, Yuuichirou, Tsukuba-shi Ibaraki 300-4247 (JP); KUREBAYASHI, Tetsuya, Mishima-gun Osaka 618-0021 (JP); AITA, Tetsuya, Mishima-gun Osaka 618-0021 (JP); MORITA, Takeharu, Mishima-gun Osaka 618-0021 (JP)
(74) Representative: Cabinet Beau de Loménie
(86) International application number: PCT/JP2017/035025
(87) International publication number: WO 2018/062307

(56) References cited:
- EP-A2- 2 228 467
- JP-A- S6 119 796
- JP-A- S61 284 971
- JP-A- 2011 108 883
- JP-A- 2011 181 887
- JP-A- 2013 253 317
- JP-A- 2016 119 468
- JP-A- 2016 119 468
- US-A1- 2014 083 508

## Description

### TECHNICAL FIELD

The present invention relates to flexible solar cells having excellent high-temperature, high-humidity durability and excellent initial performance.

### BACKGROUND ART

Laminates having an N-type semiconductor layer and a P-type semiconductor layer disposed between opposing electrodes have been actively developed as photoelectric conversion elements of solar cells. The N-type and P-type semiconductors are mainly inorganic semiconductors, such as silicon.

Attention has recently been given to perovskite solar cells in which the photoelectric conversion layer contains an organic-inorganic perovskite compound having a perovskite structure containing lead, tin, or the like as a central metal (e.g., Patent Literature 1 and 2 and Non-Patent Literature 1).

Meanwhile, flexible solar cells including a heat-resistant polymeric material (e.g., a polyimide material or polyester material) or a metal foil as the substrate are gaining attention. Flexible solar cells have advantages such as thin profile and light weight that make them easy to transport and process, and high resistance to impact.

Such a flexible solar cell is produced by stacking thin-film components such as a photoelectric conversion layer which will generate a current under irradiation with light, on a flexible substrate. If necessary, top and bottom faces of the solar cell element are each sealed with a solar cell sealing sheet.

However, flexible solar cells containing an organic-inorganic perovskite compound in the photoelectric conversion layer unfortunately have poor high-temperature, high-humidity durability.

### CITATION LIST

### - Patent Literature

**Patent** Literature 1: JP 2014-72327 A
Patent Literature 2: JP 2016-119468 A

A method of efficiently producing a flexible thin-film solar cell by a roll-to-roll process using an aluminum alloy substrate which has an oxide film of more than 1 µm to 30 µm thickness having insulating properties on a surface of an aluminum alloy containing 2.0 to 7.0 wt% of magnesium is shown in EP 2 228 467 A2.

### - Non-Patent Literature

Non-Patent Literature 1: M. M. Lee et al, Science, 2012, 338, 643

### SUMMARY OF INVENTION

### - Technical problem

The present invention aims to provide a flexible solar cell having excellent high-temperature, high-humidity durability and excellent initial performance.

### - Solution to problem

The present invention relates to a flexible solar cell of claim 1.

The present invention is described in detail below.

The use of a metal foil as the substrate in the flexible solar cell reduces the cost compared with the use of a heat-resistant polymer and also enables high-temperature treatment. However, in the case where the flexible substrate is made of a metal foil, an insulating layer is formed on the metal foil for insulation between the substrate and the electrode. The insulating layer in many cases is usually an organic insulating layer that easily absorbs moisture. In flexible solar cell submodules, the organic insulating layer makes contact also with the photoelectric conversion layer because the layers including the electrode, the photoelectric conversion layer, and the transparent electrode are each pattered such that the cells are serially connected. The present inventors found out that in the case where the photoelectric conversion layer contains an organic-inorganic perovskite compound, moisture in the air passes through the organic insulating layer to degrade the photoelectric conversion layer, leading to insufficient high-temperature, high-humidity durability.

Since organic-inorganic perovskite compounds are very sensitive to moisture, the perovskite solar cells are more likely to have the problem of low high-temperature, high-humidity durability than other solar cells (e.g., CIGS solar cells).

The present inventors also found out that use of an inorganic insulating layer instead of an organic insulating layer, particularly use of a flexible substrate including an aluminum foil and an aluminum oxide film formed on the aluminum foil, can provide excellent high-temperature, high-humidity durability even with the photoelectric conversion layer containing an organic-inorganic perovskite compound.

Such a flexible solar cell, however, disadvantageously has an insufficient initial photoelectric conversion efficiency.

The present inventors found out that either too thin or too thick an aluminum oxide film causes defects such as insulation failure, conduction failure, and cracks, resulting in insufficient initial performance. The present inventors further found out that the occurrence of these defects can be suppressed, and thus the initial performance of the flexible solar cell can be improved, by adjusting the ratio of the thickness of the aluminum oxide film to the total thickness of the aluminum foil and the aluminum oxide film within a specific range. The inventors thus completed the present invention.

The flexible solar cell of the present invention includes, on a flexible substrate, an electrode, a transparent electrode, and a photoelectric conversion layer disposed between the electrode and the transparent electrode.

The term "layer" as used herein means not only a layer having a clear boundary, but also a layer having a concentration gradient in which contained elements are gradually changed. The elemental analysis of the layer can be conducted, for example, by FE-TEM/EDS analysis and measurement of the cross section of the flexible solar cell to determine the element distribution of a particular element. The term "layer" as used herein means not only a flat thin-film layer, but also a layer capable of forming an intricate structure together with other layer(s).

The flexible substrate includes an aluminum foil and an aluminum oxide film formed on the aluminum foil.

The use of the aluminum foil reduces the cost compared with the use of a heat-resistant polymer, and also enables high-temperature treatment. For example, even when heat annealing (heat treatment) is performed at a temperature of 80°C or higher to impart light resistance (resistance to photodegradation) in formation of the photoelectric conversion layer containing an organic-inorganic perovskite compound, the occurrence of distortion can be minimized and a flexible solar cell having a high photoelectric conversion efficiency can be obtained. The use of the aluminum foil reduces the cost also compared with the use of other metal foils. In addition, the use of the aluminum foil can improve workability because of its flexibility.

The use of an inorganic insulating layer instead of an organic insulating layer, particularly use of the flexible substrate including the aluminum foil and the aluminum oxide film formed on the aluminum foil, can provide high-temperature, high-humidity durability even with the photoelectric conversion layer containing an organic-inorganic perovskite compound.

The use of the flexible substrate including the aluminum foil and the aluminum oxide film formed on the aluminum foil also can suppress the phenomenon that the photoelectric conversion layer containing an organic-inorganic perovskite compound discolors and corrodes with time due to a contact with the aluminum foil.

The discoloration caused by reaction of the photoelectric conversion layer with aluminum has not been reported in other common solar cells. The above corrosion phenomenon was found by the present inventors as a problem peculiar to perovskite solar cells.

Typical crystal structures of aluminum oxide include the boehmite (i.e., monohydrate) crystal structure and the bayerite (i.e., tryhydrate) crystal structure. The crystal structure of the aluminum oxide in the aluminum oxide film is preferably the boehmite crystal structure. When the aluminum oxide in the aluminum oxide film has the boehmite crystal structure, the aluminum oxide film is less likely to crack at high temperature.

The crystal structure (boehmite crystal structure or bayerite crystal structure) of the aluminum oxide in the aluminum oxide film may be determined by any method. For example, the crystal structure may be determined by a technique of observing the surface shape of the flexible substrate with an electron microscope (e.g., S-4800, available from Hitachi, Ltd.) or a technique of performing X-ray structure analysis.

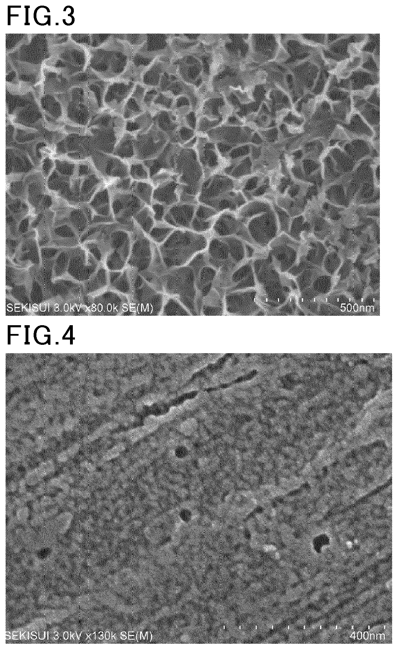

Fig. 3 is an electron micrograph of aluminum oxide having the boehmite crystal structure. Fig. 4 is an electron micrograph of aluminum oxide having the bayerite crystal structure.

A lower limit of the ratio of the thickness of the aluminum oxide film to the total thickness of the aluminum foil and the aluminum oxide film and an upper limit thereof are specified in claim 1.

When the ratio is 0.1% or higher, the aluminum oxide film has an increased hardness, allowing favorable patterning of the electrode, for example, with a laser or by mechanical scribing while suppressing peeling of the aluminum oxide film. This can suppress the occurrence of insulation failure and conduction failure and thereby improve the initial performance of the flexible solar cell. The patterning of the electrode, for example, with a laser or by mechanical scribing, is usually performed on the electrode after the electrode is disposed on the aluminum oxide film side of the flexible substrate.

When the ratio is 15% or lower, it is possible to suppress cracking of the aluminum oxide film due to a difference in coefficient of thermal expansion between the aluminum oxide film and the aluminum foil during heat treatment in formation of the photoelectric conversion layer containing an organic-inorganic perovskite compound. This can also suppress cracking of the electrode and thus suppress an increase in resistance of the flexible solar cell, thereby improving the initial performance of the flexible solar cell. It is also possible to suppress corrosion of the photoelectric conversion layer due to exposure of the aluminum foil by cracking of the aluminum oxide film. The lower limit of the ratio is preferably 0.5%.

The lower limit of the total thickness of the aluminum foil and the aluminum oxide film is specifically preferably 5 µm and the upper limit thereof is preferably 500 µm. When the total thickness is 5 µm or greater, the flexible solar cell can have sufficient mechanical strength and excellent handleability. When the total thickness is 500 µm or smaller, the flexible solar cell can have excellent flexibility. The lower limit of the total thickness is more preferably 10 µm and the upper limit thereof is more preferably 100 µm.

The lower limit of thickness of the aluminum oxide film is specifically preferably 0.1 µm and the upper limit thereof is preferably 20 µm. The lower limit is more preferably 0.5 µm and the upper limit is more preferably 10 µm. The aluminum oxide film having a thickness of 0.5 µm or greater can sufficiently cover the surface of the aluminum foil, thus stabilizing the insulation between the aluminum foil and the electrode. The aluminum oxide film having a thickness of 10 µm or smaller is less likely to crack even when the flexible substrate is curved.

The total thickness of the aluminum foil and the aluminum oxide film and the thickness of the aluminum oxide film can be measured by, for example, observing a cross section of the flexible substrate with an electron microscope (e.g., S-4800, available from Hitachi, Ltd.) and analyzing the contrast of the obtained photograph.

The aluminum oxide film may be produced by any method. Examples of the method include a method of forming the aluminum oxide film on a surface of the aluminum foil by anodizing the aluminum foil. Other examples include a method of forming the aluminum oxide film by applying an alkoxide or the like of aluminum on a surface of the aluminum foil, and a method of forming a natural oxide film on a surface of the aluminum foil by heat treatment. Preferred among them is a method of forming the aluminum oxide film on a surface of the aluminum foil by anodizing the aluminum foil, because this method can uniformly oxidize the entire surface of the aluminum foil.

In anodization, the ratio of the thickness of the aluminum oxide film to the total thickness of the aluminum foil and the aluminum oxide film may be adjusted within the above range by, for example, changing the treatment concentration, the treatment temperature, the current density, the treatment time, and the like.

The electrode is disposed on the aluminum oxide film side of the flexible substrate.

Either of the electrode and the transparent electrode may serve as the cathode or the anode. Examples of the material for the electrode and the transparent electrode include fluorine-doped tin oxide (FTO), sodium, sodium-potassium alloys, lithium, magnesium, aluminum, magnesium-silver mixtures, magnesium-indium mixtures, aluminum-lithium alloys, Al/Al₂O₃ mixtures, Al/LiF mixtures, metals such as gold, CuI, conductive transparent materials such as indium tin oxide (ITO), SnO₂, aluminum zinc oxide (AZO), indium zinc oxide (IZO) and gallium zinc oxide (GZO), and conductive transparent polymers. These materials may be used alone or may be used in combination of two or more thereof.

The photoelectric conversion layer contains an organic-inorganic perovskite compound.

The use of the organic-inorganic perovskite compound in the photoelectric conversion layer can improve the photoelectric conversion efficiency of the flexible solar cell. The organic-inorganic perovskite compound is preferably represented by the formula R-M-X₃ where R is an organic molecule, M is a metal atom, and X is a halogen or chalcogen atom.

R is an organic molecule and is preferably represented by C₁NₘHₙ (1, m and n each represent a positive integer).

Specific examples of R include methylamine, ethylamine, propylamine, butylamine, pentylamine, hexylamine, dimethylamine, diethylamine, dipropylamine, dibutylamine, dipentylamine, dihexylamine, trimethylamine, triethylamine, tripropylamine, tributylamine, tripentylamine, trihexylamine, ethylmethylamine, methylpropylamine, butylmethylamine, methylpentylamine, hexylmethylamine, ethylpropylamine, ethylbutylamine, imidazole, azole, pyrrole, aziridine, azirine, azetidine, azete, imidazoline, carbazole, methylcarboxyamine, ethylcarboxyamine, propylcarboxyamine, butylcarboxyamine, pentylcarboxyamine, hexylcarboxyamine, formamidinium, guanidine, aniline, pyridine and their ions (e.g., methylammonium (CH₃NH₃)), and phenethylammonium. Among them, methylamine, ethylamine, propylamine, propylcarboxyamine, butylcarboxyamine, pentylcarboxyamine, formamidinium, guanidine and their ions are preferred, and methylamine, ethylamine, pentylcarboxyamine, formamidinium, guanidine and their ions are more preferred. For higher photoelectric conversion efficiency, still more preferred are methylamine, formamidinium and their ions.

M is a metal atom. Examples thereof include lead, tin, zinc, titanium, antimony, bismuth, nickel, iron, cobalt, silver, copper, gallium, germanium, magnesium, calcium, indium, aluminum, manganese, chromium, molybdenum, and europium. Among these, lead or tin is preferred in view of the electron orbital overlap. These metal atoms may be used alone or may be used in combination of two or more thereof.

X is a halogen or chalcogen atom. Examples thereof include chlorine, bromine, iodine, sulfur, and selenium. These halogen or chalcogen atoms may be used alone or may be used in combination of two or more thereof. Among them, a halogen atom is preferred because the organic-inorganic perovskite compound containing halogen in the structure is soluble in an organic solvent and is usable in an inexpensive printing method or the like. In addition, iodine is more preferred because the organic-inorganic perovskite compound has a narrow energy band gap.

The organic-inorganic perovskite compound preferably has a cubic crystal structure where the metal atom M is placed at the body center, the organic molecule R is placed at each vertex, and the halogen or chalcogen atom X is placed at each face center.

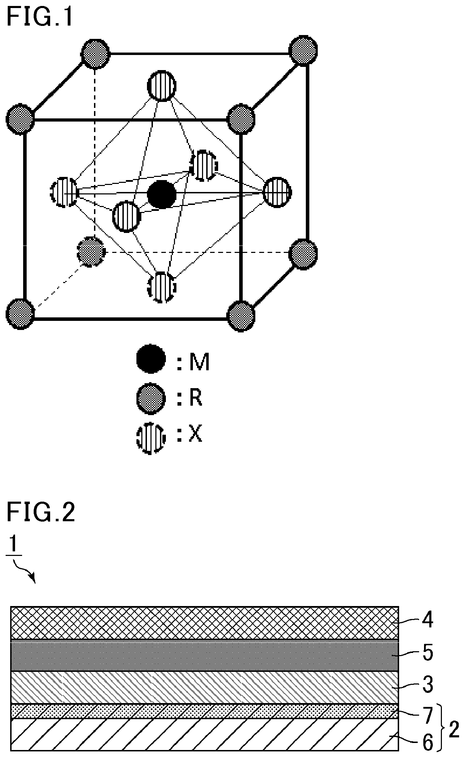

Fig. 1 is a schematic view illustrating an exemplary crystal structure of the organic-inorganic perovskite compound having a cubic crystal structure where the metal atom M is placed at the body center, the organic molecule R is placed at each vertex, and the halogen atom or chalcogen atom X is placed at each face center. Although details are not clear, it is presumed that the direction of an octahedron in the crystal lattice can be easily changed owing to the structure; thus the mobility of electrons in the organic-inorganic perovskite compound is enhanced, improving the photoelectric conversion efficiency of the flexible solar cell.

The organic-inorganic perovskite compound is preferably a crystalline semiconductor. The crystalline semiconductor means a semiconductor whose scattering peak can be detected by the measurement of X-ray scattering intensity distribution.

When the organic-inorganic perovskite compound is a crystalline semiconductor, the mobility of electrons in the organic-inorganic perovskite compound is enhanced, improving the photoelectric conversion efficiency of the flexible solar cell. When the organic-inorganic perovskite compound is a crystalline semiconductor, the reduction in the photoelectric conversion efficiency due to continuous irradiation of the flexible solar cell with light (photodegradation), in particular, photodegradation caused by lowering of the short circuit current is more likely to be suppressed.

The degree of crystallinity may also be evaluated as an index of crystallization. The degree of crystallinity can be determined by separating a crystalline substance-derived scattering peak from an amorphous portion-derived halo, which are detected by X-ray scattering intensity distribution measurement, by fitting, determining their respective intensity integrals, and calculating the ratio of the crystalline portion to the whole.

The lower limit of the degree of crystallinity of the organic-inorganic perovskite compound is preferably 30%. When the degree of crystallinity is 30% or more, the mobility of electrons in the organic-inorganic perovskite compound is enhanced, improving the photoelectric conversion efficiency of the flexible solar cell. When the degree of crystallinity is 30% or more, the reduction in the photoelectric conversion efficiency due to continuous irradiation of the flexible solar cell with light (photodegradation), in particular, photodegradation caused by lowering of the short circuit current is more likely to be suppressed. The lower limit of the degree of crystallinity is more preferably 50%, still more preferably 70%.

Examples of the method for increasing the degree of crystallinity of the organic-inorganic perovskite compound include heat annealing (heat treatment), irradiation with light having strong intensity, such as laser, and plasma irradiation.

The crystallite size may be evaluated as another index of crystallization. The crystallite size can be calculated by the halder-wagner method from the half width of a crystalline substance-derived scattering peak determined by X-ray scattering intensity distribution measurement.

When the crystallite size of the organic-inorganic perovskite compound is 5 nm or greater, the reduction in the photoelectric conversion efficiency due to continuous irradiation of the flexible solar cell with light (photodegradation), in particular, photodegradation caused by lowering of the short circuit current is more likely to be suppressed. In addition, the mobility of electrons in the organic-inorganic perovskite compound is enhanced, improving the photoelectric conversion efficiency of the flexible solar cell. The lower limit of the crystallite size is more preferably 10 nm, still more preferably 20 nm.

The photoelectric conversion layer may further contain an organic semiconductor or inorganic semiconductor, in addition to the organic-inorganic perovskite compound, as long as the effect of the present invention is not impaired.

Examples of the organic semiconductor include compounds having a thiophene skeleton, such as poly(3-alkylthiophene). Examples thereof also include conductive polymers having a poly-p-phenylenevinylene skeleton, a polyvinylcarbazole skeleton, a polyaniline skeleton, a polyacetylene skeleton, or the like. Examples thereof further include: compounds having a phthalocyanine skeleton, a naphthalocyanine skeleton, a pentacene skeleton, a porphyrin skeleton such as a benzoporphyrin skeleton, a spirobifluorene skeleton or the like; and carbon-containing materials such as carbon nanotube, graphene, and fullerene, which may be surface-modified.

Examples of the inorganic semiconductor include titanium oxide, zinc oxide, indium oxide, tin oxide, gallium oxide, tin sulfide, indium sulfide, zinc sulfide, CuSCN, Cu₂O, CuI, MoO₃, V₂O₅, WO₃, MoS₂, MoSe₂, and Cu₂S.

The photoelectric conversion layer containing the organic-inorganic perovskite compound and the organic semiconductor or inorganic semiconductor may be a laminate where a thin-film organic semiconductor or inorganic semiconductor part and a thin-film organic-inorganic perovskite compound part are stacked, or may be a composite film where an organic semiconductor or inorganic semiconductor part and an organic-inorganic perovskite compound part are combined. The laminate is preferred from the viewpoint that the production process is simple. The composite film is preferred from the viewpoint that the charge separation efficiency of the organic semiconductor or inorganic semiconductor can be improved.

The lower limit of the thickness of the thin-film organic-inorganic perovskite compound part is preferably 5 nm and the upper limit thereof is preferably 5,000 nm. When the thickness is 5 nm or greater, the thin-film organic-inorganic perovskite compound part can sufficiently absorb light to improve the photoelectric conversion efficiency. When the thickness is 5,000 nm or smaller, formation of a region in which charge separation cannot be achieved can be suppressed, leading to higher photoelectric conversion efficiency. The lower limit of the thickness is more preferably 10 nm and the upper limit thereof is more preferably 1,000 nm. The lower limit of the thickness is still more preferably 20 nm and the upper limit thereof is still more preferably 500 nm.

When the photoelectric conversion layer is a composite film where an organic semiconductor or inorganic semiconductor part and an organic-inorganic perovskite compound part are combined, the lower limit of the thickness of the composite film is preferably 30 nm and the upper limit thereof is preferably 3,000 nm. When the thickness is 30 nm or greater, light can be sufficiently absorbed, enhancing the photoelectric conversion efficiency. When the thickness is 3,000 nm or smaller, charge easily arrives at the electrode, enhancing the photoelectric conversion efficiency. The lower limit of the thickness is more preferably 40 nm and the upper limit thereof is more preferably 2,000 nm. The lower limit of the thickness is still more preferably 50 nm and the upper limit thereof is still more preferably 1,000 nm.

The photoelectric conversion layer is preferably subjected to heat annealing (heat treatment) after formation of the photoelectric conversion layer. The heat annealing (heat treatment) can sufficiently increase the degree of crystallinity of the organic-inorganic perovskite compound in the photoelectric conversion layer, further suppressing the reduction in the photoelectric conversion efficiency due to continuous irradiation with light (photodegradation). When a flexible solar cell including a conventional flexible substrate containing a heat-resistant polymer is subjected to such heat annealing (heat treatment), distortion occurs during annealing due to a difference in coefficient of linear expansion between the flexible substrate and the photoelectric conversion layer. This makes it difficult to achieve a high photoelectric conversion efficiency. In the present invention, the use of the aluminum foil can minimize the occurrence of distortion even when heat annealing (heat treatment) is performed. Thus, a flexible solar cell having a high photoelectric conversion efficiency can be obtained.

In the case of performing the heat annealing (heat treatment), the heating temperature of the photoelectric conversion layer is not particularly limited and is preferably 100°C or higher and lower than 200°C. When the heating temperature is 100°C or higher, the degree of crystallinity of the organic-inorganic perovskite compound can be sufficiently increased. When the heating temperature is lower than 200°C, the heat treatment can be carried out without thermally degrading the organic-inorganic perovskite compound. The heating temperature is more preferably 120°C or higher and 170°C or lower. The heating time is not particularly limited and is preferably three minutes or longer and two hours or shorter. When the heating time is three minutes or longer, the degree of crystallinity of the organic-inorganic perovskite compound can be sufficiently increased. When the heating time is two hours or shorter, the heat treatment can be carried out without thermally degrading the organic-inorganic perovskite compound.

These heating operations are preferably performed in vacuum or in an inert gas atmosphere. The dew-point temperature is preferably 10°C or lower, more preferably 7.5°C or lower, still more preferably 5°C or lower.

The flexible solar cell of the present invention may have an electron transport layer between the electrode or the transparent electrode, whichever serves as the cathode, and the photoelectric conversion layer.

Examples of the material of the electron transport layer include, but are not particularly limited to, N-type conductive polymers, N-type low-molecular organic semiconductors, N-type metal oxides, N-type metal sulfides, alkali metal halides, alkali metals, and surfactants. Specific examples thereof include cyano group-containing polyphenylenevinylene, boron-containing polymers, bathocuproine, bathophenanthroline, hydroxyquinolinatoaluminum, oxadiazole compounds, benzimidazole compounds, naphthalenetetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

The electron transport layer may consist only of a thin-film electron transport layer (buffer layer) and preferably includes a porous electron transport layer. In particular, when the photoelectric conversion layer is a composite film where an organic semiconductor or inorganic semiconductor part and an organic-inorganic perovskite compound part are combined, a composite film is preferably formed on a porous electron transport layer because a more complicated composite film (more intricate structure) is obtained, enhancing the photoelectric conversion efficiency.

The lower limit of the thickness of the electron transport layer is preferably 1 nm, and the upper limit thereof is preferably 2,000 nm. When the thickness is 1 nm or greater, holes can be sufficiently blocked. When the thickness is 2,000 nm or smaller, the layer is less likely to be the resistance to the electron transport, enhancing the photoelectric conversion efficiency. The lower limit of the thickness of the electron transport layer is more preferably 3 nm, and the upper limit thereof is more preferably 1,000 nm. The lower limit of the thickness is still more preferably 5 nm, and the upper limit thereof is still more preferably 500 nm.

The flexible solar cell of the present invention may have a hole transport layer between the photoelectric conversion layer and the electrode or the transparent electrode, whichever serves as the anode.

Examples of the material of the hole transport layer include, but are not particularly limited to, P-type conductive polymers, P-type low-molecular organic semiconductors, P-type metal oxides, P-type metal sulfides, and surfactants. Specific examples thereof include compounds having a thiophene skeleton such as poly(3-alkylthiophene). Examples thereof also include conductive polymers having a triphenylamine skeleton, a polyparaphenylenevinylene skeleton, a polyvinylcarbazole skeleton, a polyaniline skeleton, a polyacetylene skeleton, or the like. Examples thereof further include compounds having a phthalocyanine skeleton, a naphthalocyanine skeleton, a pentacene skeleton, a porphyrin skeleton such as a benzoporphyrin skeleton, a spirobifluorene skeleton, or the like. Examples also include molybdenum oxide, vanadium oxide, tungsten oxide, nickel oxide, copper oxide, tin oxide, molybdenum sulfide, tungsten sulfide, copper sulfide, tin sulfide, fluoro group-containing phosphonic acid, carbonyl group-containing phosphonic acid, copper compounds such as CuSCN and CuI, and carbon-containing materials such as carbon nanotube and graphene.

The hole transport layer may partly merge with the photoelectric conversion layer (it may form an intricate structure together with the photoelectric conversion layer) or may be disposed in the shape of a thin film on the photoelectric conversion layer. When the hole transport layer is in the shape of a thin film, the lower limit of the thickness of the hole transport layer is preferably 1 nm, and the upper limit thereof is preferably 2,000 nm. When the thickness is 1 nm or greater, electrons can be sufficiently blocked. When the thickness is 2,000 nm or smaller, the layer is less likely to be the resistance to the hole transport, enhancing the photoelectric conversion efficiency. The lower limit of the thickness is more preferably 3 nm, and the upper limit thereof is more preferably 1,000 nm. The lower limit of the thickness is still more preferably 5 nm, and the upper limit thereof is still more preferably 500 nm.

The flexible solar cell of the present invention may include a sealing material sealing the above-described laminate including, on the flexible substrate, the electrode, the transparent electrode, the photoelectric conversion layer disposed between the electrode and the transparent electrode, and optionally the electron transport layer and the hole transport layer.

The sealing material is not particularly limited as long as it has barrier properties. The sealing material may be a thermosetting resin, a thermoplastic resins, or an inorganic material.

Examples of the thermosetting resin and the thermoplastic resin include epoxy resin, acrylic resin, silicone resin, phenolic resin, melamine resin, urea resin, butyl rubber, polyester, polyurethane, polyethylene, polypropylene, polyvinyl chloride, polystyrene, polyvinyl alcohol, polyvinyl acetate, ABS resin, polybutadiene, polyamide, polycarbonate, polyimide, and polyisobutylene.

When the sealing material is a thermosetting resin or a thermoplastic resin, the lower limit of the thickness of the sealing layer (resin layer) is preferably 100 nm, and the upper limit thereof is preferably 100,000 nm. The lower limit of the thickness is more preferably 500 nm, and the upper limit thereof is more preferably 50,000 nm. The lower limit is still more preferably 1,000 nm, and the upper limit is still more preferably 20,000 nm.

Examples of the inorganic material include an oxide, a nitride, or an oxynitride of Si, Al, Zn, Sn, In, Ti, Mg, Zr, Ni, Ta, W, Cu, or an alloy containing two or more of them. Among them, an oxide, a nitride, or an oxynitride of metal elements including both of the metal elements Zn and Sn is preferred because water vapor barrier property and plasticity can be imparted to the sealing material.

When the sealing material is an inorganic material, the lower limit of the thickness of the sealing layer (inorganic layer) is preferably 30 nm, and the upper limit thereof is preferably 3,000 nm. When the thickness is 30 nm or greater, the inorganic layer can have a sufficient water vapor barrier property, improving the durability of the flexible solar cell. When the thickness is 3,000 nm or smaller, only small stress is generated even when the thickness of the inorganic layer is increased. Therefore, peeling of the inorganic layer from the laminate can be suppressed. The lower limit of the thickness is more preferably 50 nm, and the upper limit thereof is more preferably 1,000 nm. The lower limit of the thickness is still more preferably 100 nm, and the upper limit thereof is still more preferably 500 nm.

The thickness of the inorganic layer can be measured using an optical interference-type film thickness measurement apparatus (e.g., FE-3000 available from Otsuka Electronics Co., Ltd.).

The laminate may be covered with the thermosetting resin or the thermoplastic resin among the above sealing materials by any method. Examples of the method include a method which involves sealing the laminate using a sheet-shaped sealing material, a method which involves applying an sealing material solution containing the sealing material dissolved in an organic solvent to the laminate, a method which involves applying a liquid monomer that serves as the sealing material to the laminate, followed by crosslinking or polymerization of the liquid monomer using heat, UV, or the like, and a method which involves melting the sealing material under heat, followed by cooling.

The method for covering the laminate with the inorganic material among the above sealing materials is preferably a vacuum deposition method, a sputtering method, a chemical vapor deposition (CVD) method, or an ion plating method. Among them, a sputtering method is preferred for forming a dense layer. The sputtering method is more preferably a DC magnetron sputtering method.

In the sputtering method, the inorganic layer containing the inorganic material can be formed by depositing raw materials including a metal target and oxygen gas or nitrogen gas on the laminate for film formation.

The sealing material may contain the thermosetting resin or thermoplastic resin and the inorganic material in combination.

In the flexible solar cell of the present invention, the sealing material may be further covered with, for example, an additional material such as resin film, inorganic material-coated resin film, or metal (e.g., aluminum) foil. Specifically, the flexible solar cell of the present invention may be configured such that sealing, filling, or bonding between the laminate and the additional material is attained by the sealing material. This can sufficiently block water vapor even when a pinhole is present in the sealing material, and can further improve the durability of the flexible solar cell.

The flexible solar cell of the present invention is preferably a submodule.

The flexible solar cell of the present invention preferably has a structure which includes a plurality of cells and in which the layers including the electrode, the electron transport layer, the photoelectric conversion layer, the hole transport layer, and the transparent electrode are each patterned such that the cells are serially connected. The layers may be patterned, for example, with a laser or by mechanical scribing.

Fig. 2 is a schematic view of an exemplary flexible solar cell of the present invention. In Fig. 2, a flexible solar cell 1 includes, on a flexible substrate 2, an electrode 3, a transparent electrode 4, and a photoelectric conversion layer 5 disposed between these electrodes. The flexible substrate 2 includes an aluminum foil 6 and an aluminum oxide film 7 formed on the aluminum foil 6. Although not shown, the electrode 3, the transparent electrode 4, and the photoelectric conversion layer 5 disposed between these electrodes are each preferably patterned.

Since the flexible substrate 2 includes the aluminum foil 6 and the aluminum oxide film 7, the flexible solar cell 1 has excellent high-temperature, high-humidity durability even with the photoelectric conversion layer 5 containing an organic-inorganic perovskite compound. Moreover, since the ratio of the thickness of the aluminum oxide film 7 to the total thickness of the aluminum foil 6 and the aluminum oxide film 7 is within the above range, the occurrence of defects such as insulation failure, conduction failure, and cracks are suppressed, leading to improvement of the initial performance.

The flexible solar cell of the present invention may be produced by any method. Examples of the method include a production method including the steps of: forming the electrode on the aluminum oxide film side of the flexible substrate; disposing the electron transport layer on the electrode; disposing the photoelectric conversion layer on the electron transport layer; disposing the hole transport layer on the photoelectric conversion layer; and disposing the transparent electrode on the hole transport layer.

In production of the flexible substrate, the aluminum oxide film may be formed on the aluminum foil by any method. As described above, the aluminum oxide film is preferably formed on a surface of the aluminum foil by anodizing the aluminum foil.

### - Advantageous Effects of Invention

The present invention can provide a flexible solar cell having excellent high-temperature, high-humidity durability and excellent initial performance.

### BRIEF DESCRIPTION OF DRAWINGS

Fig. 1 is a schematic view of an exemplary crystal structure of an organic-inorganic perovskite compound.
Fig. 2 is a schematic cross-sectional view of an exemplary flexible solar cell of the present invention.
Fig. 3 is an electron micrograph of aluminum oxide having the boehmite crystal structure.
Fig. 4 is an electron micrograph of aluminum oxide having the bayerite crystal structure.

### DESCRIPTION OF EMBODIMENTS

Embodiments of the present invention, which is defined in the claims, are more specifically described in the following with reference to examples, of which only Examples 1 to 2 and 5 to 8 illustrate the invention.

### (Example 1)

### (1) Anodization of aluminum foil

An aluminum foil (available from UACJ, thickness 100 µm) was anodized with sulfuric acid to form an aluminum oxide film on a surface of the aluminum foil. Thus, a flexible substrate was obtained.

A cross section of the obtained flexible substrate was observed with an electron microscope (S-4800, available from Hitachi, Ltd.) and the contrast of the obtained photograph was analyzed to measure the thickness of the flexible substrate (the total thickness of the aluminum foil and the aluminum oxide film) and the thickness of the aluminum oxide film. The ratio of the thickness of the aluminum oxide film to the total thickness of the aluminum foil and the aluminum oxide film was calculated from the obtained thicknesses. A surface of the obtained flexible substrate was observed with an electron microscope (S-4800, available from Hitachi, Ltd.) and the crystal structure of the aluminum oxide in the aluminum oxide film was determined to be the boehmite crystal structure.

### (2) Production of flexible solar cell

On the aluminum oxide film side of the obtained flexible substrate were formed, with a deposition device, a 100-nm-thick electrode containing aluminum and a 100-nm-thick, thin-film electron transport layer containing titanium. To the thin-film electron transport layer was further applied, by a spin coating method, a titanium oxide paste containing polyisobutyl methacrylate as an organic binder and titanium oxide (mixture of particles having an average particle size of 10 nm and particles having an average particles size of 30 nm). The paste was then fired at 200°C for 10 minutes and irradiated with UV for 10 minutes. Thus, a 500-nm-thick porous electron transport layer was formed.

Subsequently, lead iodide as a metal halide compound was dissolved in N,N-dimethylformamide (DMF) to prepare a 1 M solution. The solution was formed into a film on the porous electron transport layer by a spin coating method. Separately, methylammonium iodide as an amine compound was dissolved in 2-propanol to prepare a 1 M solution. The above sample with the lead iodide film formed thereon was immersed in this solution to form a layer containing CH₃NH₃PbI₃, which is an organic-inorganic perovskite compound. The obtained sample was annealed at 120°C for 30 minutes.

Then, a solution was prepared by dissolving, in 25 µL of chlorobenzene, 68 mM of Spiro-OMeTAD (having a spirobifluorene skeleton), 55 mM of t-butylpyridine, and 9 mM of bis(trifluoromethanesulfonyl)imide-silver salt. The solution was applied to the photoelectric conversion layer by a spin coating method. Thus, a 150-nm-thick hole transport layer was formed.

A 100-nm-thick ITO film as a transparent electrode was formed on the obtained hole transport layer by vacuum evaporation. Thus, a flexible solar cell was obtained.

### (Examples 2 to 9)

A flexible solar cell was obtained as in Example 1 except that the thickness of the aluminum oxide film and the ratio thereof were adjusted as shown in Table 1 by adjusting the thickness of the aluminum foil used and the treatment time or treatment temperature in anodization.

### (Comparative Examples 1, 2, 8, and 9)

A flexible solar cell was obtained as in Example 1 except that the thickness of the aluminum oxide film and the ratio thereof were adjusted as shown in Table 1 by adjusting the thickness of the aluminum foil used and the treatment time in anodization.

### (Comparative Example 3)

A flexible solar cell was obtained as in Example 1 except that a polyimide resin layer was formed instead of the aluminum oxide film by applying polyimide on the surface of the aluminum foil and firing the polyimide.

### (Comparative Example 4)

A flexible solar cell was obtained as in Example 1 except that a PEN film was used instead of the flexible substrate including the aluminum foil and the aluminum oxide film.

### (Comparative Example 5)

A flexible substrate was obtained as in Example 2 and a 300-nm-thick ITO film was formed by sputtering on the aluminum oxide film side of the flexible substrate.

Subsequently, a 50-nm-thick polyethylenedioxidethiophene:polystyrene sulfonate (PEDOT:PSS) as a hole transport layer was formed on the ITO film by a spin coating method.

To the obtained hole transport layer was then applied, by spin coating, a 4% by weight solution in chlorobenzene of a fullerene derivative (PC60BM) and a conductive polymer (PTB-7) mixed at a weight ratio of 1:1. Thus, a photoelectric conversion layer was obtained.

Subsequently, a solution of titaniumtetraisopropyl in ethanol was applied to the obtained photoelectric conversion layer by a spin coating method. Thus, a 10-nm-thick electron transport layer was obtained.

A 100-nm-thick ITO film as a transparent electrode was formed on the obtained electron transport layer by vacuum evaporation. Thus, a flexible solar cell was obtained.

### (Comparative Examples 6 and 7)

A flexible solar cell was obtained as in Comparative Example 5 except that the same flexible substrate as that of Comparative Example 3 or 4 was used.

<Evaluation>

The flexible solar cells obtained in the examples and comparative examples were evaluated as follows. Table 1 shows the results.

### (1) Initial performance (initial conversion efficiency)

A power source (236 model, available from Keithley Instruments Inc.) was connected between the electrodes of the flexible solar cell. The photoelectric conversion efficiency was measured at an exposure area of 0.01 cm² using a solar simulator (available from Yamashita Denso Corp.) having an intensity of 100 mW/cm², and the obtained photoelectric conversion efficiency was taken as the initial conversion efficiency.
∘ (Good): The initial conversion efficiency was 8% or higher.
× (Poor): The initial conversion efficiency was lower than 8%.

### (2) Submodule performance

Flexible solar cell submodules were produced using the same layer structures as those of the examples and comparative examples.

Each submodule was produced as follows: After the electrode was formed on the aluminum oxide film side of the flexible substrate, the electrode was divided into six sections by mechanical scribing. The production process after the division to the formation of the hole transport layer was the same as that of the corresponding example or comparative example. After the formation of the hole transport layer, mechanical scribing was performed to cut through the hole transport layer and other layers to expose the electrode. Then, the transparent layer was formed as in the corresponding example or comparative example. After formation of the transparent electrode, the transparent electrode was divided into six sections by mechanical scribing. Thus, the layers were patterned such that six cells were serially connected, whereby a submodule was obtained.

A power source (236 model, available from Keithley Instruments Inc.) was connected between the electrodes of the obtained flexible solar cell submodule. The photoelectric conversion efficiency was measured at an exposure area of 9 cm² using a solar simulator (available from Yamashita Denso Corp.) having an intensity of 100 mW/cm². The ratio of the obtained photoelectric conversion efficiency to the initial photoelectric conversion efficiency obtained in (1) was calculated. The evaluation was based on the following criteria.
∘∘∘ (Outstanding): The ratio was 0.8 or higher and 1 or lower to the initial conversion efficiency.
∘∘ (Excellent): The ratio was 0.6 or higher and lower than 0.8 to the initial conversion efficiency.
∘ (Good): The ratio was 0.4 or higher and lower than 0.6 to the initial conversion efficiency.
× (Poor): The ratio was lower than 0.4 to the initial conversion efficiency.

### (3) Insulation test

Resistance was measured with a tester at randomly selected 10 sites on the flexible substrate.
∘∘ (Excellent): The resistance did not reach 50 MΩ or higher at zero site.
∘ (Good): The resistance did not reach 50 MΩ or higher at one to three sites.
× (Poor): The resistance did not reach 50 MΩ or higher at four or more sites.

### (4) Resistivity test

An electrode containing aluminum and an electron transport layer were formed on the flexible substrate and fired at 200°C for 10 minutes. The resistance was then measured with a tester.
∘∘ (Excellent): The resistance was lower than 10 Ω.
∘ (Good): The resistance was 10 Ω or higher and lower than 50 Ω.
× (Poor): The resistance was 50 Ω or higher.

### (5) Corrosion of photoelectric conversion layer due to contact with aluminum foil

The flexible solar cell submodule obtained above was put in a darkroom environment at a temperature of 25°C and a dew-point of -10°C for 150 hours. The photoelectric conversion layer containing the organic-inorganic perovskite compound was observed to determine the presence or absence of a portion that changed in color from black or brown to transparent or pale yellow in the photoelectric conversion layer.
∘ (Good): The discolored portion was absent.
× (Poor): The discolored portion was present.

### (6) High-temperature, high-humidity durability

A power source (236 model, available from Keithley Instruments Inc.) was connected between the electrodes of the obtained flexible solar cell submodule. The photoelectric conversion efficiency was measured at an exposure area of 9 cm² using a solar simulator (available from Yamashita Denso Corp.) having an intensity of 100 mW/cm². The obtained photoelectric conversion efficiency was taken as the initial conversion efficiency. Thereafter, the flexible solar cell submodule was placed in an environment at 85°C and a humidity of 85% for 100 hours to perform a high-temperature, high-humidity durability test. The photoelectric conversion efficiency after the high-temperature, high-humidity durability test was measured in the same manner as the initial conversion efficiency. The value of (the photoelectric conversion efficiency after the high-temperature, high-humidity durability test)/(the initial conversion efficiency) was determined.
∘∘ (Excellent): The value of (the photoelectric conversion efficiency after the high-temperature, high-humidity durability test)/(the initial conversion efficiency) was 0.9 or higher.
∘ (Good): The value of (the photoelectric conversion efficiency after the high-temperature, high-humidity durability test)/(the initial conversion efficiency) was 0.8 or higher and lower than 0.9.
× (Poor): The value of (the photoelectric conversion efficiency after the high-temperature, high-humidity durability test)/(the initial conversion efficiency) was lower than 0.8.

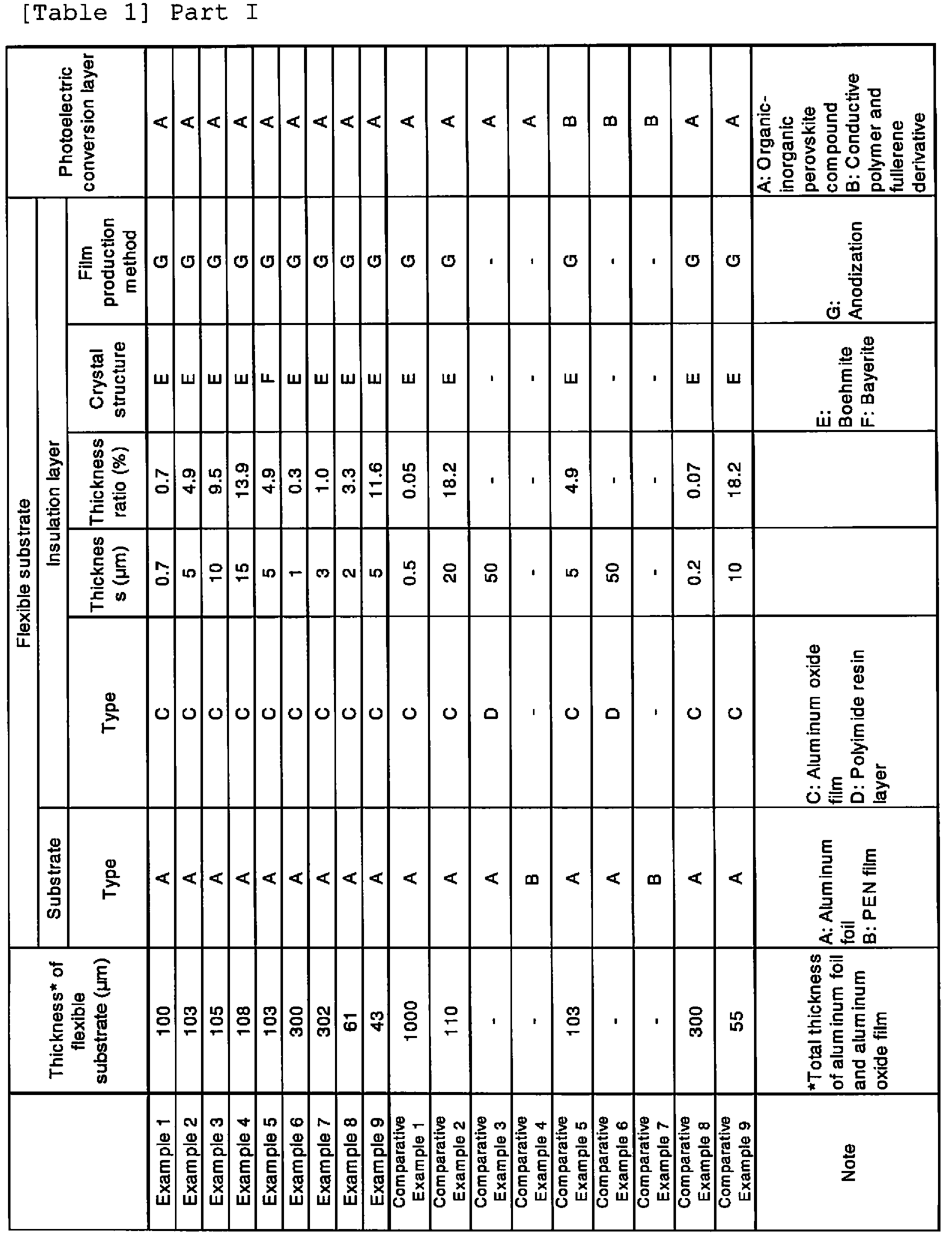

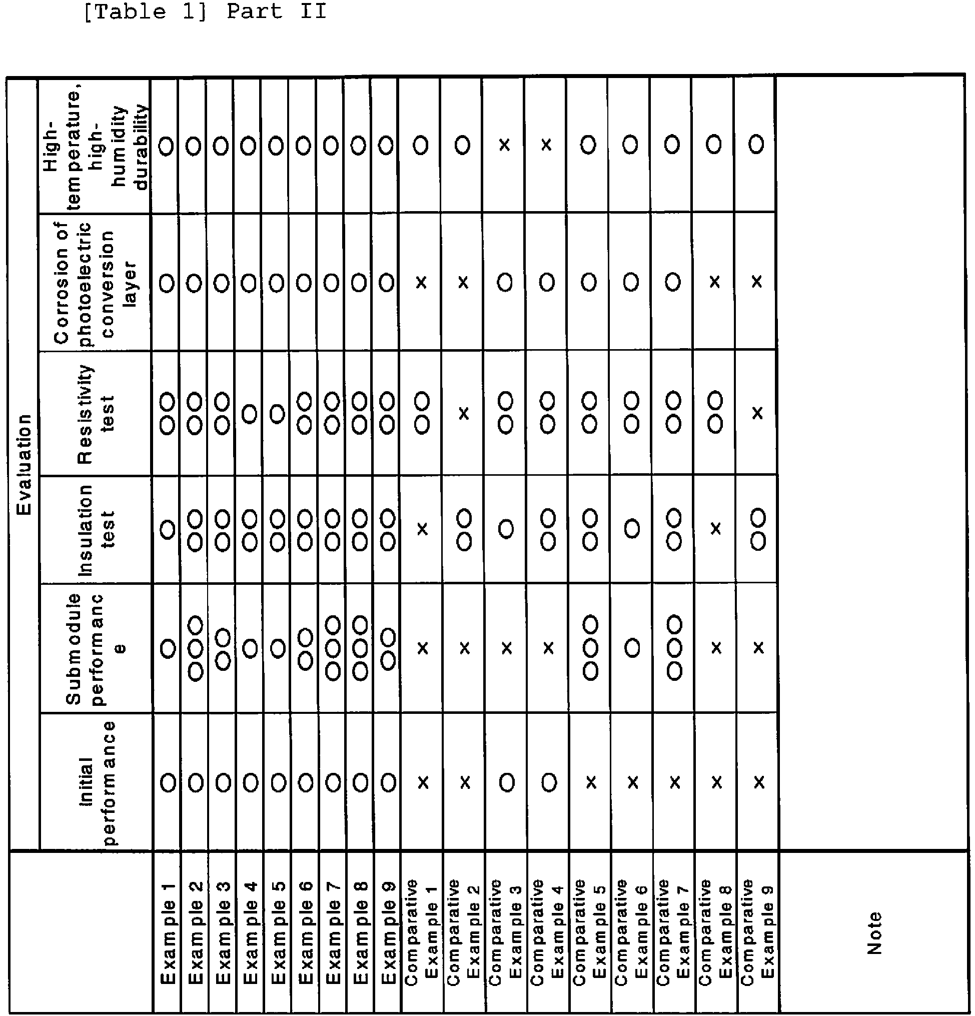

### INDUSTRIAL APPLICABILITY

The present invention can provide a flexible solar cell having excellent high-temperature, high-humidity durability and excellent initial performance.

### REFERENCE SIGNS LIST

- 1: flexible solar cell
- 2: flexible substrate
- 3: electrode
- 4: transparent electrode
- 5: photoelectric conversion layer
- 6: aluminum foil
- 7: aluminum oxide film

## Claims

1. A flexible solar cell (1) comprising, on a flexible substrate (2):
an electrode (3);
a transparent electrode (4); and
a photoelectric conversion layer (5) disposed between the electrode (3) and the transparent electrode (4),
the photoelectric conversion layer (5) containing an organic-inorganic perovskite compound,
the flexible substrate (2) including an aluminum foil (6), **characterised in that** an aluminum oxide film (7) is formed on the aluminum foil with a ratio of the thickness of the aluminum oxide film (7) to the total thickness of the aluminum foil (6) and the aluminum oxide film of 0.1% or higher and 5% or lower.

2. The flexible solar cell (1) according to claim 1,
wherein the thickness of the aluminum oxide film (7) is 0.1 µm or greater and 20 µm or smaller.

3. The flexible solar cell (1) according to claim 1 or 2,
wherein the organic-inorganic perovskite compound is represented by the formula R-M-X₃ where R is an organic molecule, M is a metal atom, and X is a halogen or chalcogen atom.

## Patentansprüche

1. Flexible Solarzelle (1), umfassend auf einem flexiblen Substrat (2):
eine Elektrode (3),
eine transparente Elektrode (4) und
eine photoelektrische Umwandlungsschicht (5), die zwischen der Elektrode (3) und der transparenten Elektrode (4) angeordnet ist,
wobei die photoelektrische Umwandlungsschicht (5) eine organisch-anorganische Perowskitverbindung enthält,
wobei das flexible Substrat (2) eine Aluminiumfolie (6) aufweist,
**dadurch gekennzeichnet, dass**
ein Aluminiumoxidfilm (7) auf der Aluminiumfolie ausgebildet ist, mit einem Verhältnis der Dicke des Aluminiumoxidfilms (7) zu der Gesamtdicke der Aluminiumfolie (6) und des Aluminiumoxidfilms von 0,1 % oder höher und 5 % oder niedriger.

2. Flexible Solarzelle (1) nach Anspruch 1,
wobei die Dicke des Aluminiumoxidfilms (7) 0,1 µm oder mehr und 20 µm oder weniger beträgt.

3. Flexible Solarzelle (1) nach Anspruch 1 oder 2,
wobei die organisch-anorganische Perowskitverbindung durch die Formel R-M-X₃ dargestellt ist, wobei R ein organisches Molekül ist, M ein Metallatom ist und X ein Halogen- oder Chalkogenatom ist.

## Revendications

1. Cellule photovoltaïque flexible (1) comprenant, sur un substrat flexible (2) :
une électrode (3) ;
une électrode transparente (4) ; et
une couche de conversion photoélectrique (5) disposée entre l'électrode (3) et l'électrode transparente (4),
la couche de conversion photoélectrique (5) contenant un composé pérovskite organique-inorganique,
le substrat flexible (2) incluant une feuille d'aluminium (6),
**caractérisée en ce qu'**un film d'oxyde d'aluminium (7) est formé sur la feuille d'aluminium avec un rapport de l'épaisseur du film d'oxyde d'aluminium (7) à l'épaisseur totale de la feuille d'aluminium (6) et du film d'oxyde d'aluminium de 0,1 % ou supérieur et 5 % ou inférieur.

2. Cellule photovoltaïque flexible (1) selon la revendication 1,
dans laquelle l'épaisseur du film d'oxyde d'aluminium (7) est de 0,1 µm ou supérieure et 20 µm ou inférieure.

3. Cellule photovoltaïque flexible (1) selon la revendication 1 ou 2,
dans laquelle le composé pérovskite organique-inorganique est représenté par la formule R-M-X₃ où R est une molécule organique, M est un atome de métal, et X est un atome d'halogène ou chalcogène.
